# EUROPEAN PATENT APPLICATION

(11) **EP 4 174 954 A1**
(43) Date of publication of application: **03.05.2023**
(21) Application number: 22204221.0
(22) Date of filing: 27.10.2022
(51) Int. Cl.: H01L 29/08, H01L 29/78, H01L 29/40, H01L 21/02, H01L 21/336

(54) **OXIDE FIELD TRENCH POWER MOSFET WITH A MULTI EPITAXIAL LAYER SUBSTRATE CONFIGURATION**

(30) Priority: 31.10.2021 US 202163273975 P; 10.10.2022 US 202217962634
(71) Applicant: STMicroelectronics Pte Ltd., Singapore 569508 (SG)
(72) Inventor: YONG, Yean Ching, 550537 Singapore (SG); JIN, Jianhua, 550117Singapore (SG); YAP, Weiyang, 670172 Singapore (SG); NGWAN, Voon Cheng, 732686 Singapore (SG)
(74) Representative: Cabinet Beaumont

(57) **Abstract**

A semiconductor substrate includes: a base substrate layer doped with a first type dopant; a first epitaxial layer on the base substrate layer that has a first thickness and is doped with the first type dopant to provide a first resistivity; a second epitaxial layer on the first epitaxial layer that has a second thickness and is doped with the first type dopant to provide a second resistivity (less than the third resistivity); and a third epitaxial layer on the second epitaxial layer that has a third thickness and is doped with the first type dopant to provide a third resistivity (less than the second resistivity). An oxide field trench transistor includes a trench with insulated polygate and polysource regions extending into the semiconductor substrate and passing through the first doped region, the second doped region, the third epitaxial layer and partially into the second epitaxial layer.

## Description

### CROSS REFERENCE TO RELATED APPLICATION

This application claims priority from United States Provisional Application for Patent No. 63/273,975, filed October 31, 2021, the disclosure of which is incorporated herein by reference.

### TECHNICAL FIELD

Embodiments herein generally relate to a metal oxide semiconductor field effect transistor (MOSFET) device and, in particular, to an arrangement of multiple epitaxial layers in the substrate supporting the transistor device to provide for improved reverse-biased body-drift diode break down and power conduction loss operating characteristics.

### BACKGROUND

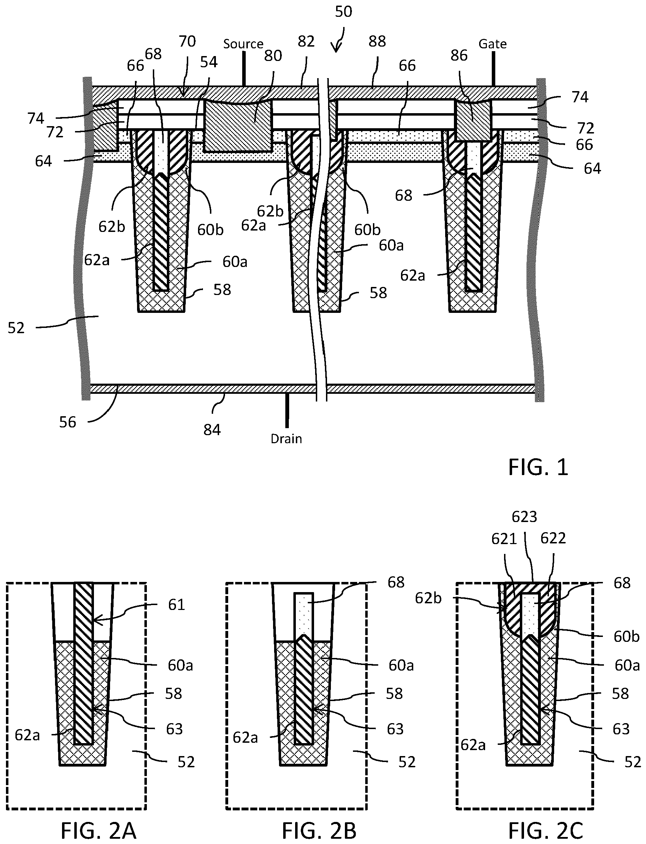

Reference is made to Figure 1 which shows a cross-section of an oxide field trench type power metal oxide semiconductor field effect transistor (MOSFET) device 50. In this example, the MOSFET is an n-channel (nMOS) type device formed in and on a semiconductor substrate 52 doped with n-type dopant which provides the drain of the transistor 50. The substrate 52 has a front side 54 and a back side 56. A plurality of trenches 58 extend depthwise into the substrate 52 from the front side 54. The trenches 58 extend lengthwise (i.e., longitudinally) parallel to each other in a direction perpendicular to the cross-section (i.e., into and out the page of the illustration) and form strips (this type of transistor device commonly referred to in the art as a strip-FET type transistor).

A region 64 doped with a p-type dopant is buried in the substrate 52 at a depth offset from (i.e., below) the front side 54 and positioned extending parallel to the front side 54 on opposite sides of each trench 58. The doped region 64 forms the body (channel) region of the transistor, with the trench 58 passing completely through the doped body region 64 and into the substrate 52 below the doped body region 64. A region 66 doped with an n-type dopant is provided at the front side 54 of the substrate 52 and positioned extending parallel to the front side 54 on opposite sides of each trench 58 and in contact with the top of the doped body region 64. The doped region 66 forms the source of the transistor, with the trench 58 passing completely through the doped source region 66 and further extending, as noted above, completely through the doped body region 64 into the substrate 52 below the doped body region 64.

The side walls and bottom of each trench 58 are lined with a first (thick) insulating layer 60a. For example, the insulating layer 60a may comprise a thick oxide layer. The trench 58 is then filled by a first polysilicon material 62a, with the insulating layer 60a insulating the first polysilicon material 62a from the substrate 52. The polysilicon material 62a is a heavily n-type doped polysilicon material (for example, Phosphorus doped with a doping concentration of 5 x 1020 at/cm3). During the process for fabricating the transistor 50, an upper portion of the insulating layer 60a (which would be adjacent to both the doped body region 64 and doped region 66) is removed from the trench 58 to expose a corresponding upper portion 61 of the polysilicon material 62a (see, Figure 2A). This exposed upper portion 61 of the polysilicon material 62a is then converted (for example, using a thermal oxidation process) to form a polyoxide region 68 that is vertically aligned in the trench 58 with the remaining (lower) portion 63 of the polysilicon material 62a (See, Figure 2B). This remaining lower portion 63 of the polysilicon material 62a forms a field plate electrode of the transistor 50 (referred to also as the polysource region because it is typically electrically shorted to the source region 66 - this electrical connection is not explicitly shown in the figures) . The side walls and bottom of the upper portion of each trench 58 are then lined with a second (thin) insulating layer 60b (see, Figure 2C). For example, the insulating layer 60b may comprise a thermally grown thin oxide layer. The upper portion of each trench 58 is then filled by a second polysilicon material 62b, with the insulating layer 60b insulating the second polysilicon material 62b from the substrate 52 (including regions 64 and 66) . The second polysilicon material 62b forms the gate (referred to also as a polygate region) of the transistor 50 and includes a first (for example, left) gate lobe 621 and second (for example, right) gate lobe 622 which extend on opposite sides of the polyoxide region 68. The first and second gate lobes are electrically coupled by a gate bridge portion 623 extending over the polyoxide region 68. The insulating layer 60b forms the gate oxide layer.

A stack 70 of layers is formed above the upper surface of the substrate. The stack 70 includes an undoped oxide (for example, tetraethyl orthosilicate (TEOS)) layer 72 and a glass (for example, borophosphosilicate glass (BPSG)) layer 74. The stack 70 may further include additional insulating and/or barrier layers if needed.

With reference to the left side of Figure 1, a source metal contact 80 extends through the layers of the stack 70, positioned between the locations of adjacent trenches 58, to make electrical contact with the doped source region 66. Each source metal contact 80 extends depthwise into the substrate to pass through the doped source region 66 and partially into the doped body region 64 (thus providing a body contact for the transistor 50 that is tied to the source) . A source metal layer 82 extends over both the stack 70 and the source metal contacts 80 to provide an electrical connection to and between all source metal contacts 80. The layers of the stack 70 insulate both the source metal layer 82 and the source metal contacts 80 from the polygate (second polysilicon region 62b).

With reference now to the right side of Figure 1, a gate metal contact 86 extends through the layers of the stack 70, positioned in alignment with the locations of the trenches 58, to make electrical contact with the second polysilicon region 62b in each trench 58 (for example, by making contact at the location of the bridge portion 623). It will be noted that the gate metal contact 86 preferably extends depthwise at least partially into the filled trench, for example extending into at least the upper part of the bridge portion 623 (and perhaps extending completely through the bridge portion). A gate metal layer 88 extends over both the stack 70 and the gate metal contacts 86 to provide an electrical connection to and between all gate metal contacts 86. The layers of the stack 70 insulate both the gate metal layer 88 and the gate metal contacts 86 from the source metal contacts and source regions. The polyoxide region 68 insulates the polysource region 62a from the gate metal contact 86.

The cross-sections on the left and right sides of Figure 1 are in practice actually longitudinally offset from each other in the direction perpendicular to the cross-section (i.e., into and out the page of the illustration). In this configuration, an insulating separation is provided between the source metal layer 82 and the gate metal layer 88.

A drain metal layer 84 extends over the back side 56 of the substrate 52 to provide a metal connection to the drain.

The transistor 50 could instead be a pMOS type transistor where the substrate 52 and doped source region 56 are both p-type doped and the body region 54 is n-type doped.

### SUMMARY

In an embodiment, an integrated circuit transistor device comprises a semiconductor substrate including: a base substrate layer doped with a first type dopant; a first epitaxial layer on the base substrate layer, said first epitaxial layer having a first thickness and doped with the first type dopant to provide a first resistivity; a second epitaxial layer on the first epitaxial layer, said second epitaxial layer having a second thickness and doped with the first type dopant to provide a second resistivity; and a third epitaxial layer on the second epitaxial layer, said third epitaxial layer having a third thickness and doped with the first type dopant to provide a third resistivity. The third resistivity is higher than the second resistivity and the second resistivity is higher than the first resistivity.

The integrated circuit transistor device further comprises: a first doped region buried in the semiconductor substrate providing a body; a second doped region in the semiconductor substrate providing a source, wherein the second doped region is adjacent the first doped region; a trench extending into the semiconductor substrate and passing through the first doped region, the second doped region, the third epitaxial layer and partially into the second epitaxial layer; a polysource region within the trench, said polysource region insulated from the semiconductor substrate by a first insulating layer; and a polygate region within the trench, said polygate region insulated from the semiconductor substrate by a second insulating layer.

In an embodiment, a method of fabricating a semiconductor substrate including a base substrate layer surmounted by at least three epitaxial layers comprises: in an epitaxial tool, controlling a dopant setting at a constant level; and with the constant level for the dopant setting, performing three consecutive epitaxial growth processes, wherein a different dilute level is set for each epitaxial growth process. The epitaxial growth processes form: a first epitaxial layer on the base substrate layer, said first epitaxial layer having a first resistivity controlled by a corresponding first dilute level; a second epitaxial layer on the first epitaxial layer, said second epitaxial layer having a second resistivity controlled by a corresponding second dilute level; and a third epitaxial layer on the second epitaxial layer, said third epitaxial layer having a third resistivity controlled by a corresponding third dilute level.

An embodiment provides an integrated circuit transistor device, comprising:
a semiconductor substrate including: a base substrate layer doped with a first type dopant; a first epitaxial layer on the base substrate layer, said first epitaxial layer having a first thickness and doped with the first type dopant to provide a first resistivity; a second epitaxial layer on the first epitaxial layer, said second epitaxial layer having a second thickness and doped with the first type dopant to provide a second resistivity; and a third epitaxial layer on the second epitaxial layer, said third epitaxial layer having a third thickness and doped with the first type dopant to provide a third resistivity;
wherein the third resistivity is higher than the second resistivity;
wherein the second resistivity is higher than the first resistivity;
a first doped region buried in the third epitaxial layer of the semiconductor substrate providing a transistor body;
a second doped region in the semiconductor substrate providing a transistor source, wherein the second doped region is adjacent the first doped region;
a trench extending into the semiconductor substrate and passing through the first doped region, the second doped region, the third epitaxial layer and partially into the second epitaxial layer;
a transistor polysource region within the trench, said transistor polysource region insulated from the semiconductor substrate by a first insulating layer; and
a transistor polygate region within the trench, said transistor polygate region insulated from the semiconductor substrate by a second insulating layer.

According to an embodiment, the transistor polygate region comprises: a polyoxide region over the transistor polysource region; a first gate lobe on a first side of the polyoxide region; and a second gate lobe on a second side of the polyoxide region opposite said first side.

According to an embodiment, the second epitaxial layer has a second dopant concentration, wherein the third epitaxial layer has a third dopant concentration, and wherein the second dopant concentration is greater than the third dopant concentration.

According to an embodiment, the first epitaxial layer has a first dopant concentration, wherein the second epitaxial layer has a second dopant concentration, and wherein the third dopant concentration is greater than the second dopant concentration.

According to an embodiment, the first dopant concentration has a gradient increasing as a function of depth in the first epitaxial layer.

According to an embodiment, the second dopant concentration is substantially constant as a function of depth in the second epitaxial layer.

According to an embodiment, the second epitaxial layer has a second dopant concentration configured to control a substantially constant electric field level as a function of depth in the second epitaxial layer.

According to an embodiment, the third epitaxial layer has a third dopant concentration configured to control a maximum electric field level in the third epitaxial layer.

According to an embodiment, the electronic device further comprises a source-body contact to the first and second doped regions, wherein said maximum electric field is under the source-body contact.

An embodiment provides a method of fabricating a semiconductor substrate including a base substrate layer surmounted by at least three epitaxial layers, comprising:
in an epitaxial tool:
controlling a dopant setting at a constant level; and
with the constant level for the dopant setting, performing three consecutive epitaxial growth processes, wherein a different dilute level is set for each epitaxial growth process, to:
   form a first epitaxial layer on the base substrate layer, said first epitaxial layer having a first resistivity controlled by a corresponding first dilute level;
   form a second epitaxial layer on the first epitaxial layer, said second epitaxial layer having a second resistivity controlled by a corresponding second dilute level; and
   form a third epitaxial layer on the second epitaxial layer, said third epitaxial layer having a third resistivity controlled by a corresponding third dilute level.

According to an embodiment, the third resistivity is higher than the second resistivity, and wherein the second resistivity is higher than the first resistivity.

According to an embodiment, the second epitaxial layer has a second dopant concentration, wherein the third epitaxial layer has a third dopant concentration, and wherein the second dopant concentration is greater than the third dopant concentration.

According to an embodiment, the first epitaxial layer has a first dopant concentration, wherein the second epitaxial layer has a second dopant concentration, and wherein the third dopant concentration is greater than the second dopant concentration.

According to an embodiment, the first dopant concentration has a gradient increasing as a function of depth in the first epitaxial layer.

According to an embodiment, the second dopant concentration is substantially constant as a function of depth in the second epitaxial layer,

### BRIEF DESCRIPTION OF THE DRAWINGS

For a better understanding of the embodiments, reference will now be made by way of example only to the accompanying figures in which:
Figure 1 is a cross-section of a power metal oxide semiconductor field effect transistor (MOSFET) device;
Figures 2A-2C show process steps in the manufacture of the power MOSFET device of Figure 1;
Figure 3A illustrates a first embodiment for the substrate used in the power MOSFET device of Figure 1;
Figure 3B is a graph illustrating the doping profile for the n-type dopant of the substrate shown in Figure 3A;
Figure 3C is a cross-section of the power MOSFET device as shown in Figure 1 using the first embodiment for the substrate shown in Figure 3A;
Figure 3D is a graph illustrating the electrical field in the substrate for the power MOSFET device of Figure 3C;
Figure 4A illustrates a second embodiment for the substrate used in the power MOSFET device of Figure 1;
Figure 4B is a graph illustrating the doping profile for the n-type dopant of the substrate shown in Figure 4A;
Figure 4C is a cross-section of the power MOSFET device as shown in Figure 1 using the second embodiment for the substrate shown in Figure 4A;
Figure 4D is a graph illustrating the electrical field in the substrate for the power MOSFET device of Figure 4C;
Figure 5A illustrates a comparison of static performance of the power MOSFET devices of Figures 3C and 4C in terms of BVDSS breakdown;
Figure 5B illustrates a comparison of static performance of the power MOSFET devices of Figures 3C and 4C in terms of Rdson; and
Figures 6A, 6B and 6C illustrate parameters and results for the epitaxial growth process to fabricate the second embodiment of the substrate shown in Figure 4A.

### DETAILED DESCRIPTION

For the discussion herein, it will be noted that the term "longitudinal" refers to a first direction for example extending along the length of the trench and the term "lateral" refers to a second direction for example extending along the width of the trench. The longitudinal and lateral directions are perpendicular to each other and extend parallel to an upper surface of the semiconductor substrate.

Reference and use herein of "substantially equal to" or "about" or similar terminology thereto in terms of a given quantity means a range around the given quantity plus/minus 5% (for example, "substantially equal to" or "about" 10 means a range of 9.5 to 10.5).

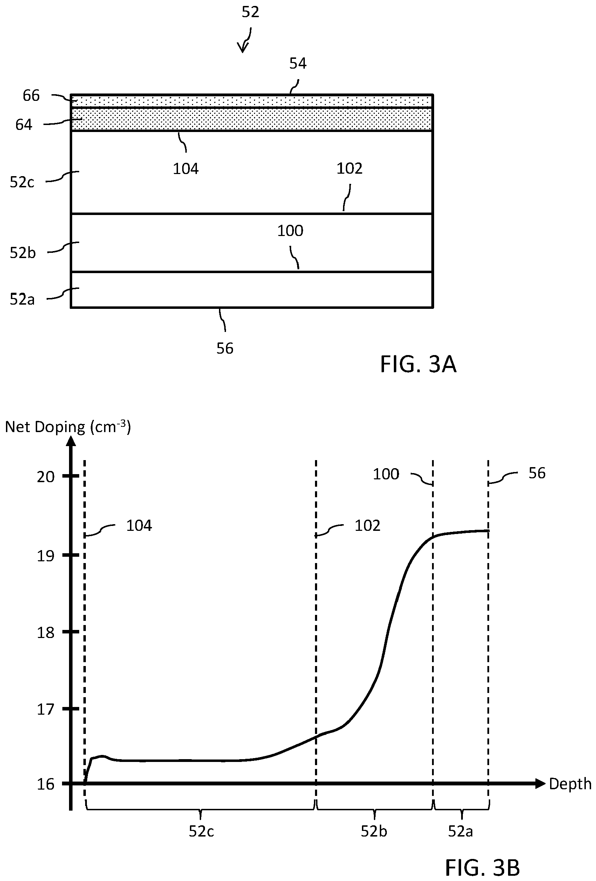

Reference is now made to Figure 3A which illustrates a first embodiment for the substrate 52 used in the power MOSFET device 50 of Figure 1. The substrate 52 with a back side 56 includes a base substrate layer 52a. A first epitaxial layer 52b overlies the base substrate layer 52a at interface 100. A second epitaxial layer 52c overlies the first epitaxial layer 52b at interface 102. Figure 3A further shows: the body region 64 within the second epitaxial layer 52c that is doped with a p-type dopant and buried in the substrate 52 at a depth offset from (i.e., below) the front side 54 and the source region 66 doped with an n-type dopant that is provided at the front side 54 of the substrate 52 adjacent the body region 64.

Figure 3B is a graph illustrating the doping profile for the n-type dopant for the base substrate layer 52a, first epitaxial layer 52b and second epitaxial layer 52c. The base substrate layer 52a is heavily doped with an n-type dopant (for example, with a generally constant doping concentration in excess of about 1 × 1019 at/cm3). The first epitaxial layer 52b is also doped with an n-type dopant (for example, with a lower doping concentration between about 5 x 1016 at/cm3 and about 1 × 1019 at/cm3). In a preferred implementation, the first epitaxial layer 52b exhibits a doping gradient where the doping concentration increases as a function of depth (i.e., increasing in concentration the closer to the interface 100 with the base substrate layer 52a). The second epitaxial layer 52c is also doped with an n-type dopant (for example, with a light doping concentration that is less than or equal to about 5 x 1016 at/cm). In a preferred implementation, the second epitaxial layer 52b exhibits a generally constant doping concentration as a function of depth from the interface 104 with the body region 64 to interface 102 with the first epitaxial layer 52b.

As an example, base substrate layer 52a may have a thickness in the range of about 1-2 µm, first epitaxial layer 52b may have a thickness in the range of about 2.5-4 µm, and second epitaxial layer 52c may have a thickness in the range of about 6-8 µm. It will, of course, be understood that the foregoing thicknesses are provided as examples only, and the circuit designer may choose the appropriate layer thicknesses based on the circuit application.

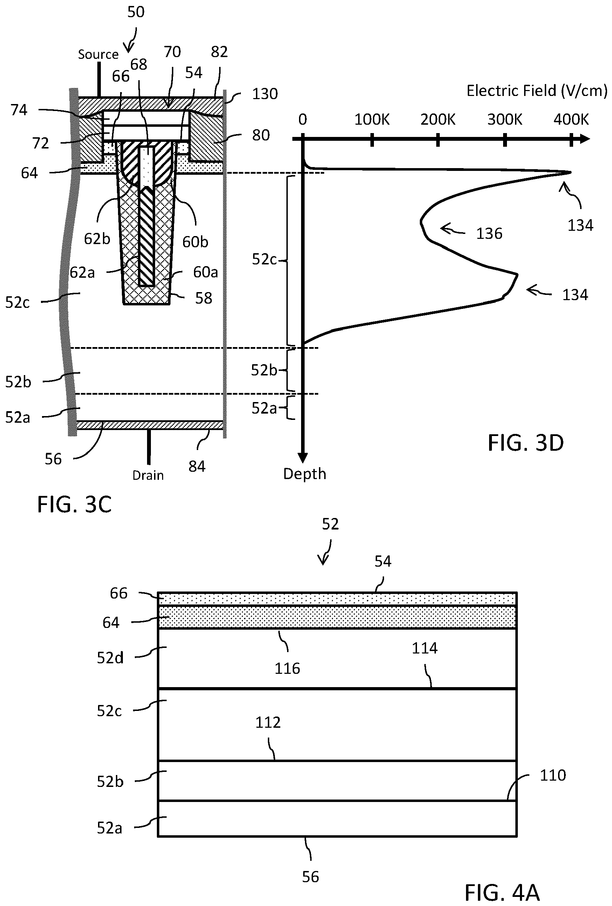

Reference is now made to Figure 3C illustrating a cross-section of a single cell of the power MOSFET device 50 as shown in Figure 1 using the first embodiment for the substrate 52 shown in Figure 3A. The first epitaxial layer 52b interfaces with the base substrate layer 52a and is a lower layer of low resistivity (for example, about 0.11 ohm*cm) due to the gradient doping concentration. The second epitaxial layer 52c forms the entire drift region of the MOSFET device 50 and is an upper layer of higher resistivity (for example, about 0.36 ohm*cm) and greater thickness (about 6.75 µm versus about 3.0 µm) than the first epitaxial layer 52b.

Figure 3D shows a graph illustrating the electrical field in the substrate 52 for the power MOSFET device of Figure 3C at the cut line 130 (which bisects the source-body contact 80) in connection with a simulation of device operation at the voltage at which the reverse-biased body-drift diode breaks down (i.e., the BVDSS breakdown condition). There are two peaks 134 in the electric field: one under the body-source contact 80 and another at the bottom of the trench 58. The highest electric field is under the body-source contact 80 associated with the first peak 134. There is a trough 136 in the electric field between the two peaks 134 in the second epitaxial layer 52c drift region. This shape of the electric field is not optimized (for example, it does not have a trapezoidal profile exhibiting a substantially constant electric field over the depth of the trench and in particular along the depth of the polysource 62a) and this has an adverse effect on power conduction loss (drain-to-source resistance in the on state (Rdson)) for the power MOSFET device of Figure 3C.

Reference is now made to Figure 4A which illustrates a second embodiment for the substrate 52 used in the power MOSFET device 50 of Figure 1. The substrate 52 has a back face 56 and includes a base substrate layer 52a. A first epitaxial layer 52b overlies the base substrate layer 52a at interface 110. A second epitaxial layer 52c overlies the first epitaxial layer 52b at interface 112. A third epitaxial layer 52d overlies the first epitaxial layer 52b at interface 114. Figure 4A further shows: the body region 64 within the third epitaxial layer 52d that is doped with a p-type dopant and buried in the substrate 52 at a depth offset from (i.e., below) the front side 54 and the source region 66 doped with an n-type dopant that is provided at the front side 54 of the substrate 52 adjacent the body region 64.

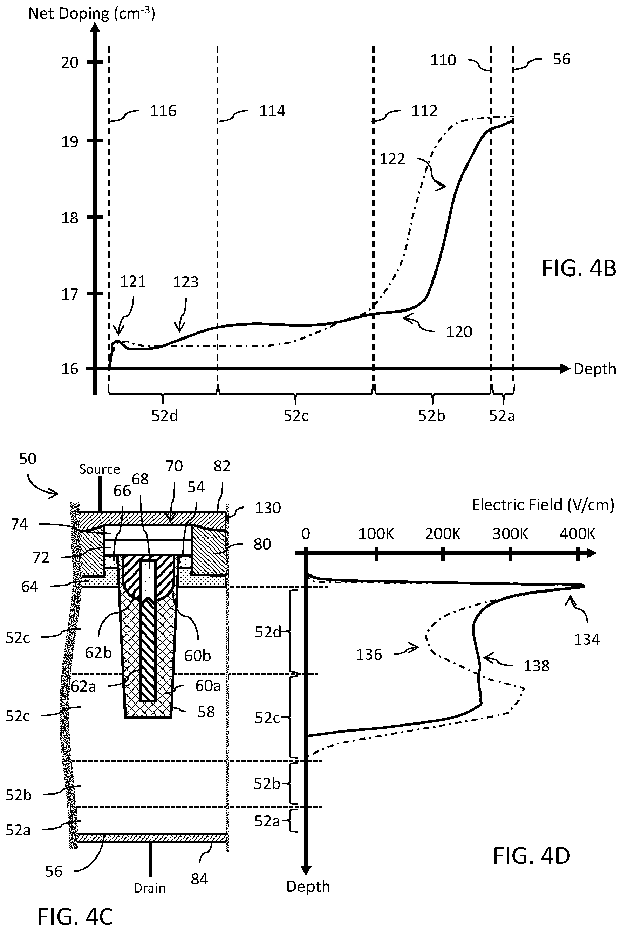

Figure 4B is a graph illustrating the doping profile for the n-type dopant for the base substrate layer 52a, first epitaxial layer 52b, second epitaxial layer 52c and third epitaxial layer 52d. Figure 4B also shows in a dash-dot line, for comparison purposes, the doping profile for the dual epi substrate configuration as shown in Figure 3B. The base substrate layer 52a is heavily doped with an n-type dopant (for example, with a generally constant doping concentration in excess of about 1 × 1019 at/cm3). The first epitaxial layer 52b is also doped with an n-type dopant (for example, with a lower doping concentration between about 5 x 1016 at/cm3 and about 1 × 1019 at/cm3). In a preferred implementation, the first epitaxial layer 52b exhibits a doping gradient where the doping concentration increases as a function of depth (i.e., increasing in concentration the closer to the interface 110 with the base substrate layer 52a). In particular, the gradient of the doping concentration in a first part 120 of the first epitaxial layer 52b is generally constant followed by a second part 122 where the doping concentration gradually increases. The second epitaxial layer 52c is also doped with an n-type dopant (for example, with a light doping concentration that is less than about 1 × 1017 at/cm). In a preferred implementation, the second epitaxial layer 52c exhibits a generally constant doping concentration as a function of depth between interface 114 and interface 112. The third epitaxial layer 52d is also doped with an n-type dopant (for example, with a light doping concentration that is less than or equal to about 5 x 1016 at/cm). In a preferred implementation, the third epitaxial layer 52d exhibits a doping gradient where the doping concentration increases as a function of depth from the interface 116 with the body region 64 to interface 114. In particular, the gradient of the doping concentration in a first part 121 of the third epitaxial layer 52d exhibits a hump with a drop off that is followed by a second part 123 where the doping concentration gradually increases.

As an example, base substrate layer 52a may have a thickness in the range of about 1-2 µm, first epitaxial layer 52b may have a thickness in the range of about 2.5-4 µm, second epitaxial layer 52c may have a thickness in the range of about 3.5-6 µm, and the third epitaxial layer 52d may have a thickness in the range of about 2-4 µm. It will, of course, be understood that the foregoing thicknesses are provided as examples only, and the circuit designer may choose the appropriate layer thicknesses based on the circuit application.

Reference is now made to Figure 4C illustrating a cross-section of the power MOSFET device 50 as shown in Figure 1 using the second embodiment for the substrate 52 shown in Figure 4A. The first epitaxial layer 52b interfaces with the base substrate layer 52a and is a lower layer of low resistivity (for example, about 0.12 ohm*cm) due to the gradient doping concentration. The drift region is formed by the second and third epitaxial layers 52c and 52d. The second epitaxial layer 52c is an intermediate layer of slightly higher resistivity (for example, about 0.19 ohm*cm) and greater thickness (about 4.1 µm versus about 3.0 µm) than the first epitaxial layer 52b. The second epitaxial layer 52c is responsible for elevating the electric field in the drift region to provide for a generally trapezoidal field shape. The third epitaxial layer 52d is an upper layer of higher resistivity (for example, about 0.52 ohm*cm) and less thickness (about 3.3 µm versus about 4.1 µm) than the second epitaxial layer 52c. The thickness and dopant concentration (see Figure 4B) in the third epitaxial layer 52d are crucial in limiting the peak electric field beneath the source-body contact 80.

Figure 4D shows a graph illustrating the electrical field in the substrate 52 for the power MOSFET device of Figure 4C at the cut line 130 (which bisects the source-body contact 80) in connection with a simulation of device operation at the voltage at which the reverse-biased body-drift diode breaks down (i.e., the BVDSS breakdown condition). Figure 4D also shows in a dash-dot line, for comparison purposes, the electric field for the dual epi substrate configuration as shown in Figure 3D. The peak 134 in the electric field under the body-source contact 80 for the multiple epi substrate configuration of Figure 4A is present and has a similar magnitude to the peak 134 for the dual epi substrate configuration. The positive effect of the second epitaxial layer 52c in elevating the electric field in the drift region to present a more trapezoidal profile 138 along the depth of the trench and its polysource 62a is clear (compare to the profile with trough 136). There is accordingly an improved performance in terms of power conduction loss (drain-to-source resistance in the on state (Rdson)).

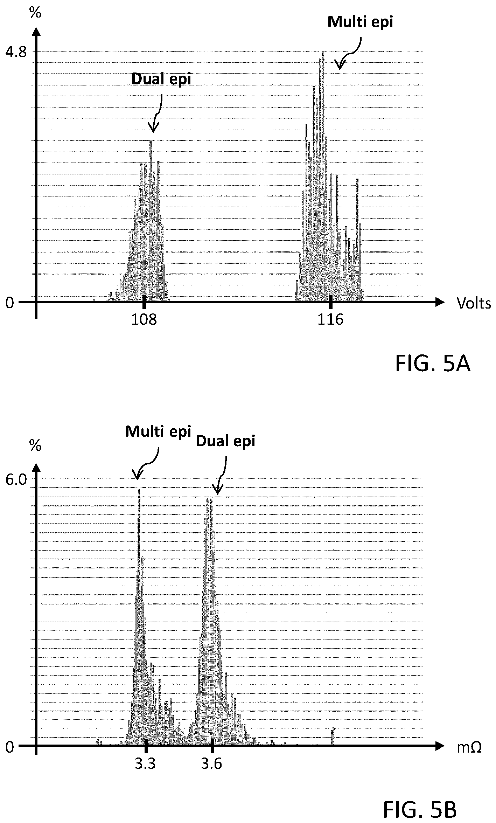

The use of the multiple epi substrate configuration of Figure 4A for a power MOSFET device like that shown in Figures 1 and 4C provides for improved static performance in terms of both of BVDSS breakdown and Rdson. See, Figure 5A (illustrating a comparison of BVDSS breakdown static performance of the power MOSFET devices of Figures 3C and 4C at 250 µA with a more than 6% improvement in BVDSS when using the multiple epi substrate compared to the dual epi substrate) and Figure 5B (illustrating a comparison of Rdson static performance of the power MOSFET devices of Figures 3C and 4C at 10 V and 11A with a more than 7 % reduction in Rdson when using the multiple epi substrate compared to the dual epi substrate).

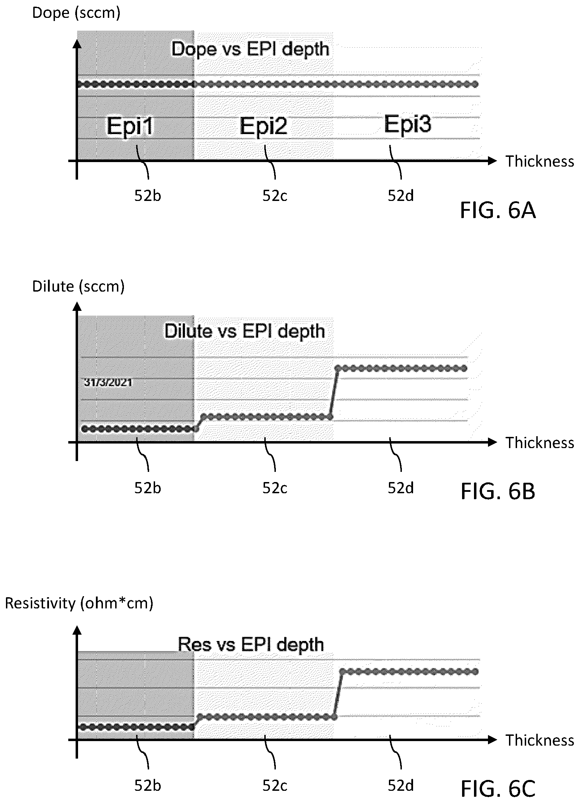

The formation of the multiple epi substrate of Figure 4A utilizes a conventional epitaxial tool well known to those skilled in the art, however there are unique aspects of the process recipe to achieve the desired structure. The recipe for the epitaxial growth of three consecutive layers (52b, 52c, 52d) utilizes a same dopant setting for each layer. To obtain a different resistivity for each layer, the dilute flow is modulated. Figure 6A illustrates setting of the dopant level for the epitaxial tool to remain constant during the epitaxial growth of the first, second and third epitaxial layers 52b, 52c and 52d (for example, at a level of between bout 150-200 sccm. Figure 6B, however, illustrates modulation of the setting for the dilute level in the epitaxial tool for the deposition each epitaxial layer (the dilute having a first, lower, level (for example, at a level of between about 500-1000 sccm) when epitaxially growing the first epitaxial layer 52b, having a second, intermediate, level (for example, at a level of between about 1000-1500 sccm) when epitaxially growing the second epitaxial layer 52c, and having a third, higher, level (for example, at a level of between about 3000-4000 sccm) when epitaxially growing the third epitaxial layer 52d). The changing of the dilute level, while keeping the dopant level constant, results in each epitaxial layer 52b, 52c and 52d having a different resistivity as shown in Figure 6C.

While the invention has been illustrated and described in detail in the drawings and foregoing description, such illustration and description are considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims.

## Claims

1. An integrated circuit transistor device, comprising:
a semiconductor substrate including: a base substrate layer doped with a first type dopant; a first epitaxial layer on the base substrate layer, said first epitaxial layer having a first thickness and doped with the first type dopant to provide a first resistivity; a second epitaxial layer on the first epitaxial layer, said second epitaxial layer having a second thickness and doped with the first type dopant to provide a second resistivity; and a third epitaxial layer on the second epitaxial layer, said third epitaxial layer having a third thickness and doped with the first type dopant to provide a third resistivity;
wherein the third resistivity is higher than the second resistivity;
wherein the second resistivity is higher than the first resistivity;
a first doped region buried in the third epitaxial layer of the semiconductor substrate providing a transistor body;
a second doped region in the semiconductor substrate providing a transistor source, wherein the second doped region is adjacent the first doped region;
a trench extending into the semiconductor substrate and passing through the first doped region, the second doped region, the third epitaxial layer and partially into the second epitaxial layer;
a transistor polysource region within the trench, said transistor polysource region insulated from the semiconductor substrate by a first insulating layer; and
a transistor polygate region within the trench, said transistor polygate region insulated from the semiconductor substrate by a second insulating layer.

2. The integrated circuit transistor device of claim 1, wherein the transistor polygate region comprises: a polyoxide region over the transistor polysource region; a first gate lobe on a first side of the polyoxide region; and a second gate lobe on a second side of the polyoxide region opposite said first side.

3. The integrated circuit transistor device of claim 1 or 2, wherein the second epitaxial layer has a second dopant concentration, wherein the third epitaxial layer has a third dopant concentration, and wherein the second dopant concentration is greater than the third dopant concentration.

4. The integrated circuit transistor device of claim 1 or 2, wherein the first epitaxial layer has a first dopant concentration, wherein the second epitaxial layer has a second dopant concentration, and wherein the third dopant concentration is greater than the second dopant concentration.

5. The integrated circuit transistor device of claim 3 or 4, wherein the first dopant concentration has a gradient increasing as a function of depth in the first epitaxial layer.

6. The integrated circuit transistor device of any of claims 3 to 5, wherein the second dopant concentration is substantially constant as a function of depth in the second epitaxial layer.

7. The integrated circuit transistor device of any of claims 1 to 8, wherein the second epitaxial layer has a second dopant concentration configured to control a substantially constant electric field level as a function of depth in the second epitaxial layer.

8. The integrated circuit transistor device of any of claims 1 to 9, wherein the third epitaxial layer has a third dopant concentration configured to control a maximum electric field level in the third epitaxial layer.

9. The integrated circuit transistor device of any of claims 1 to 10, further comprising a source-body contact to the first and second doped regions, wherein said maximum electric field is under the source-body contact.

10. A method of fabricating a semiconductor substrate including a base substrate layer surmounted by at least three epitaxial layers, comprising:
in an epitaxial tool:
controlling a dopant setting at a constant level; and
with the constant level for the dopant setting, performing three consecutive epitaxial growth processes, wherein a different dilute level is set for each epitaxial growth process, to:
form a first epitaxial layer on the base substrate layer, said first epitaxial layer having a first resistivity controlled by a corresponding first dilute level;
form a second epitaxial layer on the first epitaxial layer, said second epitaxial layer having a second resistivity controlled by a corresponding second dilute level; and
form a third epitaxial layer on the second epitaxial layer, said third epitaxial layer having a third resistivity controlled by a corresponding third dilute level.

11. The method of claim 12, wherein the third resistivity is higher than the second resistivity, and wherein the second resistivity is higher than the first resistivity.

12. The method of claim 10 or 11, wherein the second epitaxial layer has a second dopant concentration, wherein the third epitaxial layer has a third dopant concentration, and wherein the second dopant concentration is greater than the third dopant concentration.

13. The method of claim 10 or 11, wherein the first epitaxial layer has a first dopant concentration, wherein the second epitaxial layer has a second dopant concentration, and wherein the third dopant concentration is greater than the second dopant concentration.

14. The method of claim 12 or 13, wherein the first dopant concentration has a gradient increasing as a function of depth in the first epitaxial layer.

15. The method of any of claims 12 to 14, wherein the second dopant concentration is substantially constant as a function of depth in the second epitaxial layer.
